# EUROPEAN PATENT APPLICATION

(11) **EP 4 783 809 A1**
(43) Date of publication of application: **29.07.2026**
(21) Application number: 25154409.4
(22) Date of filing: 28.01.2025
(51) Int. Cl.: H10N 60/01, H10N 60/80, H10D 1/68

(54) **METHOD FOR PRODUCING A TWO-ELECTRODE DEVICE COMPRISING SUPERCONDUCTING NBTIN ELECTRODES**

(71) Applicant: IMEC VZW, 3001 Leuven (BE); Imec USA Nanoelectronics Design Center, Kissimmee, FL 34744-4430 (US)
(72) Inventor: Pokhrel, Ankit, 3001 Leuven (BE); Kim, Min-Soo, 3001 Leuven (BE); Tokei, Zsolt, 3000 Leuven (BE); Herr, Quentin, 3001 Leuven (BE); Herr, Anna, 3001 Leuven (BE); Huet, Benjamin, 3001 Leuven (BE)
(74) Representative: Patent Department IMEC

(57) **Abstract**

Disclosed is a two-electrode device, such as a Josephson junction or a capacitor, comprising top and bottom electrodes (18, 27) formed of superconducting NbTiN which are separated by a non-superconducting interlayer (17), wherein the bottom electrode is larger than the interlayer and the top electrode. The electrodes and the interlayer are formed by two separate patterning steps and embedded in an enveloping dielectric material (25, 28, 35) that is subsequently planarized by a first CMP stopping on the upper surface of the top electrode (18), thereby forming a first planarized surface (36). Thereafter, a via opening (39) is formed, exposing the upper surface of the bottom electrode (27), filled with an electrically conductive material (40), and planarized by a second CMP. Wiring conductors (57, 58) are then formed on the second planarized surface (36').

## Description

### Field of the Invention

The present invention is related to the fabrication of digital logic circuits.

### State of the art.

Superconducting digital logic (SDL) is one of the main technologies of interest for overcoming inherent limitations in terms of energy efficiency of CMOS based integrated circuits. An SDL circuit is configured to operate at temperatures near the absolute minimum and comprises electrical conductors formed of a material having superconducting properties at these low temperatures. Active devices include Josephson Junctions which enable changing the magnetic flux in a superconducting loop by an integer number of a single magnetic flux quantum (SFQ), while power delivery requires the integration of capacitors, comprising electrodes of superconducting material with a dielectric material sandwiched therebetween.

Although SDL circuits have existed for decades, there have been fundamental challenges to fabricate and scale down the circuit components and related interconnects for high density digital stacks.

An example of an SDL architecture is illustrated in patent publication document WO2023122069, with Josephson junctions and capacitors integrated in a stacked multilevel structure that is similar to the back-end-of-line stacks in standard CMOS technology. As stated, the scaling down of the various components in a multilevel structure of this type remains an ongoing challenge.

In particular, when for example a JJ device or capacitor is integrated between two adjacent interconnect levels, it is advantageous from a downscaling viewpoint to produce via connections between conductors of these two layers, wherein said conductors are contacting the electrodes of the JJ device or capacitor either directly, or indirectly, i.e. through other connections integrated in interconnect levels above or below the two adjacent levels. A fabrication method for producing such via connections that is compatible with the downscaling of dimensions and with particular materials applicable in SDL circuits is however not available at the present time. The aim of the present invention is to provide a solution to this particular problem.

### Summary of the invention

The invention is related to products and methods in accordance with the appended claims. The invention concerns the realization of a two-electrode structure suitable for implementation in an digital logic circuit. The two-electrode structure comprises a top and bottom electrode separated by a non-superconducting interlayer. The structure may be a Josephson Junction device (hereafter abbreviated as JJ device) or a capacitor for example. According to the invention, the bottom and top electrode are formed of superconducting NbTiN. In addition, the top and bottom electrode and the interlayer of the two-electrode structure are formed by patterning steps and embedded in an enveloping dielectric material that is subsequently planarized, including a CMP step that is stopped by the upper surface of the top electrode. This first planarization is followed by the formation of a via opening, thereby exposing the upper surface of the bottom electrode or of another layer portion patterned together with the patterning of said bottom electrode. The via opening is filled with electrically conductive material, followed by a second planarization. Electrical conductors are then formed on the second planarized surface.

In practice, many via connections may be produced simultaneously across a given layout produced in a die area of a semiconductor wafer. The via connections may be in physical contact with the bottom electrodes of two-electrode structures (e.g. JJ devices or capacitors) and/or with conductors in the same plane as said bottom electrodes. The bottom electrodes and conductors are part of a first interconnect level. The via connections connect this first level to conductors of a second interconnect level, with the two-electrode structures integrated between the two levels. Conductors of the second level can be connected directly or indirectly to the top electrodes. The first and second level can be situated anywhere in a multilevel structure comprising more than two levels , i.e. via connections can be connected directly or indirectly to JJ devices or capacitors integrated between various levels of the multilevel structure. The invention enables the formation of these via connections in the particular context of multilayer digital logic circuits, and thereby creates the possibility of further downscaling of such circuits, in particular of superconducting digital logic (SDL) circuits.

The invention is in particular related to a method for producing a two-electrode structure suitable for being implemented in a digital logic circuit, wherein the top and bottom electrodes are formed of superconducting NbTiN and are separated by a non-superconducting interlayer, the method comprising the steps of :
- producing a bottom layer of superconducting NbTiN on a planar support substrate,
- producing a middle layer of non-superconducting material on the bottom layer,
- producing a top layer of superconducting NbTiN on the middle layer,
- patterning the top layer and the middle layer to form a localized stack comprising the top electrode and the interlayer of the two-electrode structure, the top electrode having an upper surface,
- patterning the bottom layer to form the bottom electrode of the two-electrode structure as well as one or more additional layer portions at the same level as the bottom electrode, the bottom electrode and said layer portions having an upper surface,
- producing one or more layers of dielectric material, to thereby embed the two-electrode structure in dielectric material, said material being hereafter referred to as 'embedding dielectric material',
- in a first planarization step, planarizing the embedding dielectric material, wherein said planarizing includes a Chemical Mechanical Polishing, i.e. CMP step that is stopped on the upper surface of the top electrode, thereby obtaining a first planarized dielectric surface that is coplanar with the upper surface of the top electrode,
- thereafter, producing a via opening through said embedding dielectric material, thereby exposing, at the bottom of the via opening, the upper surface of the bottom electrode or of one of said additional layer portions,
- producing a first additional layer of electrically conductive material, thereby filling the via opening and forming an elecrically conductive layer on the first planarized surface,
- in a second planarization step, planarizing the electrically conductive layer, comprising a CMP step that is stopped on the embedding dielectric material, thereby obtaining a second planarized surface comprising a dielectric surface that is coplanar with the upper surface of the top electrode and with the upper surface of a via connection formed by filling the via opening,
- producing a second additional layer of electrically conductive material on the second planarized surface,
- patterning the second additional layer, to thereby form one or more conductors connected to the top electrode and/or to the via connection.

According to an embodiment, the step of patterning the top layer and the middle layer is performed by producing a patterned hardmask on the top layer and transferring the shape of the patterned hardmask to the top layer and the middle layer, and wherein the hardmask consists of a single layer of a dielectric material that is either removed completely during said transferring of the shape of the hardmask or that becomes part of said localized stack and of said embedding dielectric material after producing said one or more layers of dielectric material and before the first planarization step.

According to an embodiment, the method comprises :
- producing a dielectric layer conformally on the bottom electrode and the localized stack,
- producing a first enveloping dielectric layer on the conformal dielectric layer,
- planarizing the first enveloping dielectric layer, including a CMP step that is stopped on the conformal dielectric layer,
- removing the conformal dielectric layer from the upper surface of the top electrode,
- producing a second enveloping dielectric layer on the first enveloping dielectric layer to form a stack of the first and second enveloping dielectric layer,
- performing said first planarization step on the stack formed of the first and second enveloping dielectric layers, stopping on the surface of the top electrode.

According to an embodiment, the conformal layer is a single layer formed conformally on the bottom electrode and the localized stack, after the step of patterning the bottom layer.

According to an embodiment, the conformal layer is formed by depositing a first conformal layer on the localized stack before patterning the bottom layer and by depositing a second conformal layer after patterning the bottom layer.

According to an embodiment, the conformal dielectric layer is formed of silicon nitride.

According to an embodiment, the embedding dielectric material is silicon oxide.

According to an embodiment, the two-electrode structure is a Josephson Junction device.

According to an embodiment, the two-electrode structure is a capacitor.

The invention is equally related to a digital logic circuit comprising one or more Josephson junction devices and/or one or more capacitors produced by the method according to the invention.

### Brief description of the figures

Figures 1 to 25 illustrate a number of key steps of a method according to an embodiment of the invention.
Figures 26 to 28 illustrate alternative configurations obtainable by a method according to the invention.

### Detailed description of the invention

NbTiN is a material known to have superconducting properties for certain atomic concentrations of the constituent elements Nb and Ti, at temperatures below the critical temperature (which is about 17°K for NbTiN). These concentrations are expressed in the stoichiometric formula NbₓTi₁₋ₓN of the material, wherein x is the atomic percentage (in at%) of Nb. Throughout the present description, the term 'superconducting NbTiN' is defined as NbₓTi₁₋ₓN wherein x enables superconducting properties of the material below its critical temperature. More generally a 'superconducting material' is defined as a material exhibiting superconducting properties below the critical temperature of the material.

Superconducting NbTiN exhibits good stability during the various processing steps required to produce a multilevel SDL circuit, which distinguishes this material from other superconducting materials like Nb and NbN. In particular, the surface of a superconducting NbTiN layer shows low reactivity with oxygen which is advantageous when processing is performed in an oxygen-containing atmosphere.

Key method steps will now be described of a method according to an embodiment of the invention, for producing a JJ device, including electrical connections to the bottom and top electrode of the device. Device dimensions cited in the following description are purely exemplary and are not limiting the scope of the invention. The same is true for all cited materials other than NbTiN.

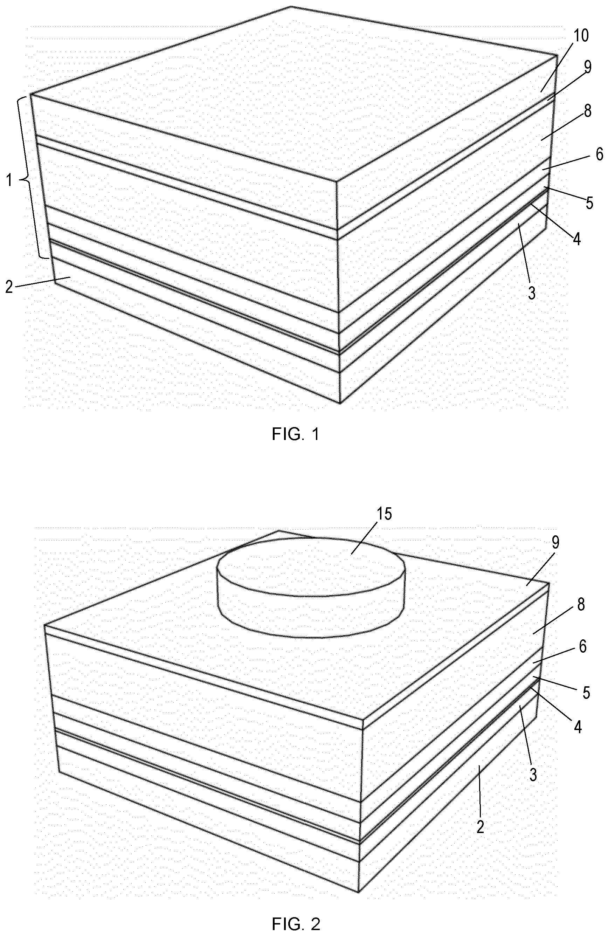

Figure 1 shows a small portion of a stack 1 of layers formed on the planar upper surface of a support layer 2. The in-plane dimensions of the illustrated stack portion are very small, in the order of a few hundred nanometres. The layers of the stack are however produced on the entire surface of the support layer 2 which may for example be formed on a standard silicon process wafer having a diameter of 200 mm or 300 mm. Layer 2 may be a dielectric layer 2 formed directly on the wafer surface or it may be a layer of a BEOL type layer stack formed on the process wafer, said layer stack including multiple interconnect levels comprising conductors embedded in consecutive layers of dielectric material. In the latter case, layer 2 is formed during the building-up process of the BEOL layer stack and the method steps of the invention are part of said process.

Method steps are described hereafter for producing a Josephson junction device in the illustrated stack portion. In practice, the method steps are applied simultaneously across the surface of the support layer 2, to thereby produce multiple JJ devices which are interconnected according to a given layout in a number of designated die areas, with a high number of devices arranged in each die area.

In the embodiment shown, the stack 1 is formed on a silicon oxide layer 2 The silicon oxide layer's compositional formula is SiO₂, with possible small deviations from the pure stoichiometric composition defined by the formula. Silicon oxide defined in this way will hereafter be referred to as 'SiOx'. However, the support layer 2 may be formed of any other suitable dielectric material or more generally, of any material that does not have superconducting properties, i.e. any material that behaves as an insulator at the temperatures at which the superconducting portions of the circuit are exhibiting superconducting properties.

On the support layer 2, a layer 3 of superconducting NbTiN is formed of about 50 nm thick, followed by an amorphous silicon layer 4 (hereafter abbreviated as 'α-Si layer') of about 5-10 nm thick, and again a superconducting NbTiN layer 5 of about 50 nm thick. More generally, layers 3 and 5 may for example be between 10 nm and 200 nm thick. These NbTiN layers 3 and 5 with the α-Si layer 4 sandwiched therebetween are respectively the bottom and top electrode layers and the barrier layer from which the electrodes and the barrier of the JJ device will be processed.

Instead of an α-Si layer, the barrier layer 4 could be a stack of a α-Si layer and on top of said α-Si layer a thin intermixed Si/Ti layer. This intermixed layer is obtainable by depositing Ti directly on a 10 nm α-Si layer under increased temperature, as described in EP application nr. EP 23213425.4 by the same applicant. The invention is however not limited by any particular type, structure or material of the barrier layer 4.

A SiOx layer 6 of about 50 nm thick is formed directly on the top electrode layer 5. Any method known in the art for producing such a layer can be applied for producing layer 6, for example atomic layer deposition (ALD) or chemical or physical vapour deposition (CVD or PVD). Another applicable method is Plasma-Enhanced CVD (PECVD).

A lithographic stack 8,9,10 is formed on the SiOx layer 6, the stack comprising : an amorphous carbon layer 8, an SiOC (silicon oxycarbide) layer 9 and a resist layer 10. This is a well-known type of litho stack, and thicknesses of its constituting layers may be in accordance with known practice. Other lithostacks could be applied and the materials of layers 8,9,10 can be chosen in accordance with known material combinations.

The resist layer 10 is patterned by exposure to light through a patterned mask and after development and stripping of the non-patterned resist, a resist mask 15 remains, as illustrated in Figure 2. The mask has a circular cross-section with a diameter of about 300 nm. Diameters from 100 nm up to 2 µm are however obtainable using the method according to the invention.

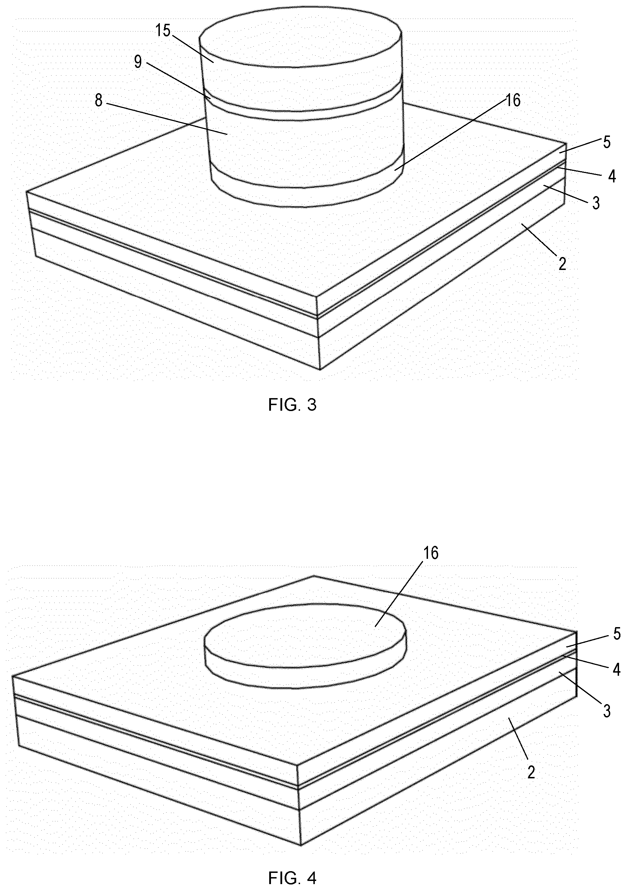

With reference to Figure 3, the resist mask 15 is then transferred by etching, to the underlying layers, the SiOC layer 9, the amorphous carbon layer 8, and the SiOx layer 6. The etching process stops on the NbTiN surface of the top layer 5, which is realized by applying an etch recipe that is selective with respect to NbTiN. Wet or dry etching is applicable for this purpose. An applicable dry etching process is a CF4 (tetrafluormethane) based plasma etch. The patterned SiOx layer 6 now becomes a patterned hardmask 16 having the same diameter as the resist mask 15.

The litho stack (resist 15, SiOC 9 and amorphous carbon 8) is then stripped relative to the NbTiN top layer 5 and the SiOx hardmask 16, resulting in the image shown in Figure 4 : only the SiOx hardmask 16 remains on top of the NbTiN top layer 5.

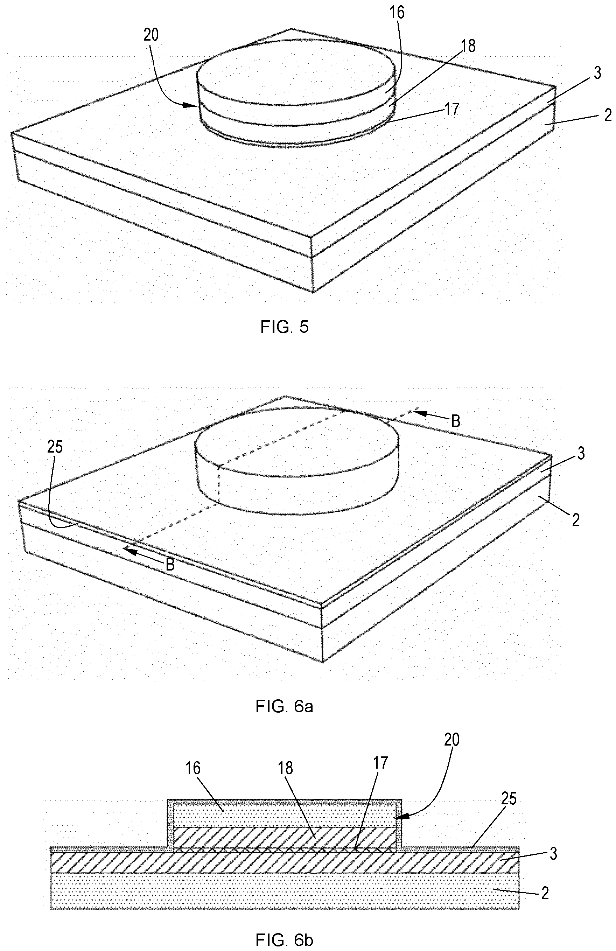

By a plasma etch process illustrated in Figure 5, the SiOx hardmask 16 is transferred to the underlying top electrode layer 5 and the barrier layer 4, i.e. the material of these layers is removed anisotropically with respect to the SiOx hardmask 16, leaving a cylindrical localized stack 20 as illustrated in Figure 5 and comprising the barrier 17 of the JJ device, the top electrode 18 of the JJ device and the SiOx hardmask 16.

Stripping the litho stack typically requires O₂ plasma etching which can be damaging to the sidewalls of the layers of the eventual JJ device. The approach described here prevents damage to the sidewalls because the litho mask layers 8,9,15 are stripped prior to etching the device layers. Said latter etch process is then a non-oxygen-based plasma etch process, for example chloride or fluoride based, that is less detrimental to the sidewall integrity and the eventual electrical performance of the JJ device.

According to the embodiment illustrated in Figure 5, the plasma etch for transferring the SiOx hardmask 16 is stopped by end point detection relative to the barrier layer material, i.e. the etching is stopped when no more species of the barrier layer 4 are detected in the etch chamber. According to another embodiment, this etch process is stopped by an etch stop layer.

Although this is not shown as such in the drawing, the thickness of the SiOx hardmask 16 may be somewhat reduced by the plasma etch process for producing the localized stack 20, compared to the thickness of the original SiOx layer 6, due to the fact that the selectivity of this process relative to SiOx is never 100 %. According to another embodiment, the original thickness of the SiOx layer 6 is tuned so that the hardmask 16 is fully consumed during the plasma etch process. The thickness of the SiOx hardmask may for example be between 30 nm and 100 nm.

Reference is now made to Figure 6a and the cross-section view in Figure 6b : according to the illustrated embodiment, a layer 25 of SiN is deposited conformally on the cylindrical stack 20, i.e. including the SiOx hardmask 16. The composition of the silicon nitride layer 25 is Si₃N₄ with possibly small deviations from the exact stoichiometric coefficients 3 and 4. Silicon nitride defined in this way will hereafter be referred to as 'SiN'. Layer 25 may alternatively be an amorphous silicon layer for example.

The deposition of the conformal SiN layer 25 is optional within the wider scope of the invention.

Layer 25 is a conformally deposited layer (hereafter also referred to as a 'conformal layer') in the sense that the layer closely follows the topography of the cylindrical stack 20, forming a vertically oriented layer on the sidewall of the cylindrical stack 20 and a horizontally oriented layer on the surface of the bottom layer 3 and of the hardmask 16. The SiN layer 25 has a thickness that enables a conformal deposition as so defined. In the illustrated embodiment, said thickness of the conformal SiN layer 25 may be in the order of 10 to 15 nm. This may be realized by physical vapour deposition or by PECVD or ALD, applied in-situ, which may refer to a deposition in the same chamber as the plasma etch process used for patterning the barrier and top electrode layers, or in a multichamber tool wherein a wafer can be moved from one chamber to another without being exposed to ambient air. The conformal SiN layer 25 is a protective dielectric encapsulation layer that protects the sidewalls of the barrier 17 and the top electrode 18 during subsequent processing steps and during air exposure.

The in-situ deposition referred to above is advantageous because it ensures that no native oxide growth occurs on the localized stack 20 prior to the deposition of the conformal layer 25. Nevertheless, it is also possible to deposit the conformal layer 'ex-situ', i.e. after exposing the localized stack 20 to nonvacuum conditions. In that case however, the deposition of the conformal layer 25 is preferably preceded by a precleaning step using a wet cleaning chemistry for removing the native oxide, or by an ion milling step.

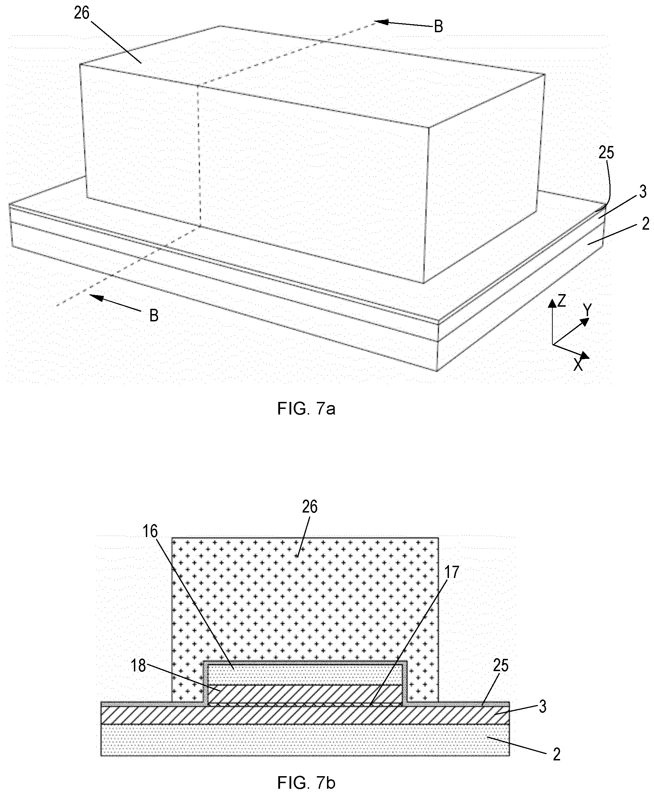

With reference to Figures 7a and 7b, a further hardmask 26 is produced extending in the X-direction of the XYZ orthogonal axis system illustrated in Figure 7a, and fully covering the cylindrical stack 20. The hardmask 26 may be formed in a manner known as such and the exact structure of the mask is not shown in detail. The hardmask 26 may be obtained by producing a stack of spin-on-carbon (SOC) and spin-on-glass (SOG) and resist followed by patterning the resist and transferring the resist pattern to the SOC/SOG stack. The width as measured in the Y-direction of the line-shaped hardmask 26 is in the order of 400 nm in the illustrated embodiment and may more generally be for example between 300 nm and 650 nm.

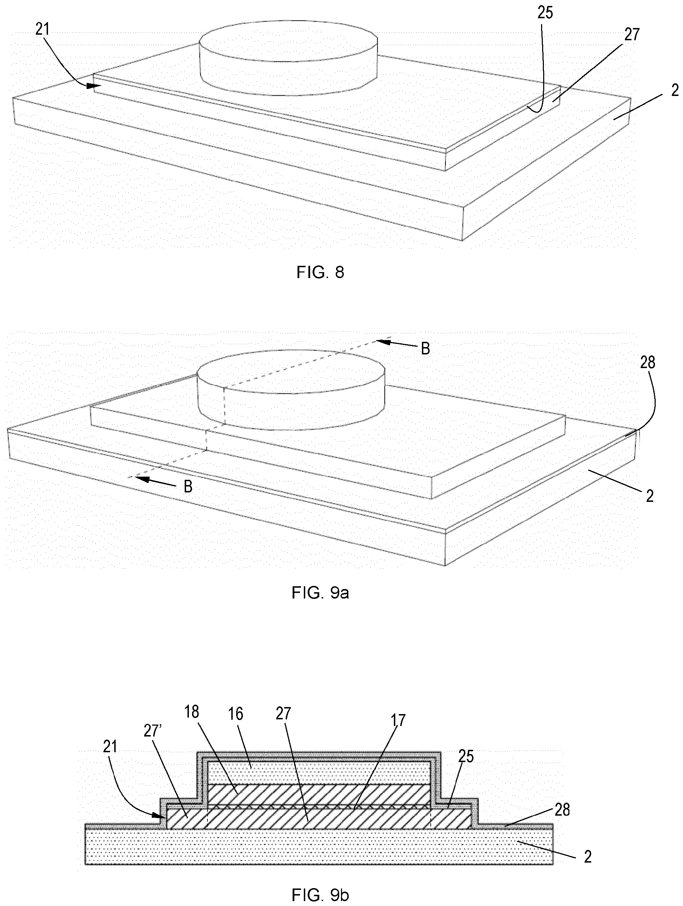

As shown in Figure 8, the hardmask 26 is transferred to the underlying conformal protection layer 25 and the bottom electrode layer 3 by a further anisotropic plasma etch, stopping on the SiOx support layer 2, so that a bottom electrode 27 is formed on said support layer 2. The image shown in Figure 8 represents the structure after stripping of the hardmask 26. In the embodiment shown, the bottom electrode 27 has a rectangular in-plane shape, extending outward in the X-direction from the round top electrode 18. This shape enables contacting the bottom electrode 27 by applying the method steps described hereafter which are in accordance with an embodiment of the invention. The invention is however not limited to this particular way of patterning the bottom NbTiN layer 3, as will be explained later in this description.

A second SiN (or for example amorphous Si) conformal layer 28 ('conformal' being as defined with reference to layer 25) may then be deposited by PVD or by PECVD or ALD, as illustrated in Figures 9a and 9b. The thickness of the second conformal layer 28 may be for example between 10nm and 15 nm. The second conformal SiN layer 28 is also optional. Layer 28 may be deposited also when no first conformal layer 25 was formed. In the latter case, the conformal layer 28 forms a single conformal layer on the topography defined by the bottom electrode 27 and the localized stack 20.

In Figures 8 and 9b, the JJ device is indicated by numeral 21, i.e. it is a two-electrode structure comprising a bottom electrode 27, a top electrode 18 and a non-superconducting interlayer 17 between the electrodes.

When both conformal layers 25 and 28 are applied, the second conformal layer 28 encapsulates the surface and sidewalls of the bottom electrode 27 whilst realizing a double encapsulation of the barrier 17 and the top electrode 18 of the JJ device. This double encapsulation by conformal layers of a dielectric material, in this case SiN, further protects the sidewalls of the device layers and enables minimizing electrical losses of the eventual JJ device. In the section view in Figure 9b, the conformal SiN layers 25 and 28 are represented as separate layers, but these layers could merge and form a uniform SiN layer, i.e. a uniform conformal layer having a higher thickness on the sidewalls of the top electrode 18 than on the bottom electrode 27.

The second conformal layer 28 can be deposited in-situ or ex-situ, as described in relation to the first conformal layer 25.

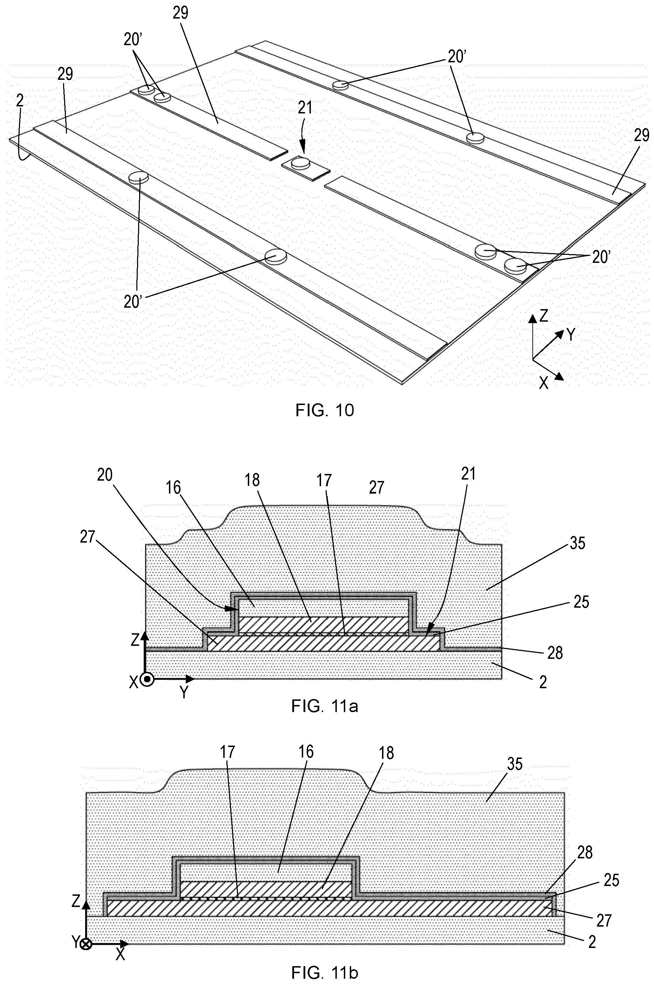

Figure 10 shows part of a possible layout comprising the JJ device 21 produced as described above. According to the illustrated layout, multiple barrier/top electrode stacks 20' have been processed simultaneously with the stack 20, in the manner described above. Furthermore, a number of parallel line-shaped conductors 29 are patterned together with the bottom electrode 27. The stacks 20' may be included as dummy devices in the layout and/or some of them may serve as JJ devices which have a common bottom electrode. Many more actual or dummy JJ-devices may be formed in this way in accordance with one or more full layouts produced in dedicated die areas of the wafer.

Method steps according to an embodiment of the invention are now described for producing contacts to the bottom and top electrodes of the JJ device 21, The method steps are described with reference to a single device, in the knowledge that in practice, these steps can be performed simultaneously for a large number of devices processed on a given wafer.

A thick layer of dielectric material 35 is deposited so as to fully envelop the JJ device 21 and the conformal layers 25,28. The layer 35 is illustrated in Figures 11a and 11b, showing cross-sections respectively in the YZ and XZ planes of the orthogonal axis system XYZ shown in Figure 10. The dielectric material 35 may be a SiOx layer or a low-K dielectric layer, or any other layer suitable as an interlayer dielectric material (ILD) in a back end of line interconnect structure as known from standard Si-based CMOS process flows.

In the illustrated example, the ILD Layer 35 is a SiOx layer of about 200 nm thick, deposited by Atomic Layer Deposition. It is seen that the upper surface of this layer still follows the topography of the bottom electrode 27 and the localized stack 20, however not in the sense of a conformal layer as defined with reference to layers 25 and 28 : the thickness of the ILD layer 35 is higher than the combined thickness of the constituent layers of the JJ device, including the conformal layers 25 and 28, so that the layer 35 fully envelops the device on all sides by a continuous volume of dielectric material. According to an embodiment (not shown), a further SiOx layer of about 300 nm is deposited by CVD on top of the ALD applied layer 35, so as to obtain a substantially planar upper ILD surface, which is beneficial (although not absolutely essential) for the subsequent planarization.

Layer 35, possibly combined with an additional CVD-applied layer is referred to in the present description and in the appended claims as an 'enveloping dielectric layer', defined here as a layer having sufficient thickness to fully envelop de topography of the bottom electrode 27 and the localized stack 20 by a continuous volume of dielectric material.

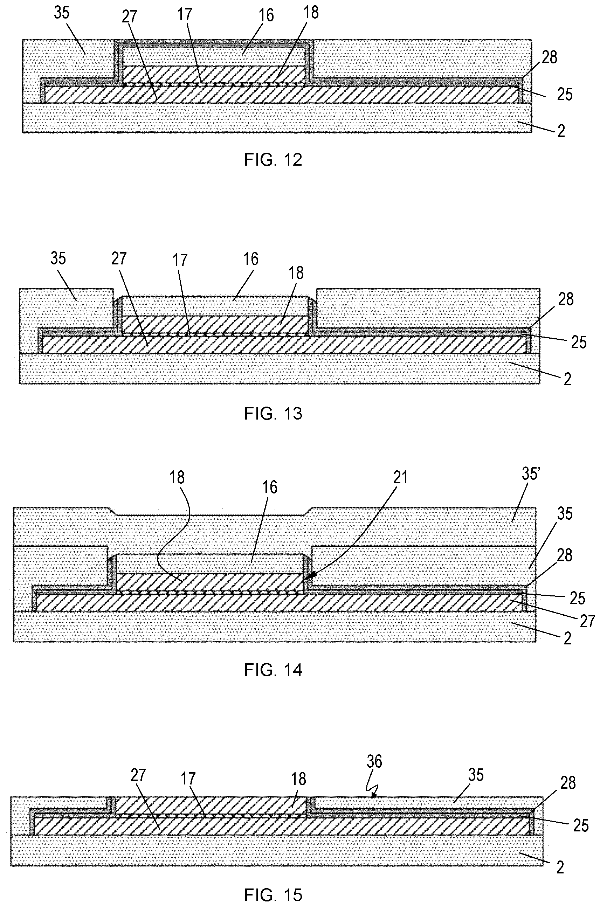

Further processing steps are now described with reference only to section views in the XZ plane. With reference to Figure 12, the ILD material 35 is planarized by standard planarization techniques, including CMP (chemical mechanical polishing), stopping on the upper surface of the double SiN encapsulation layer 25+28. CMP recipes and conditions for planarizing SiOx stopping on a SiN surface are known as such in the art.

The SiN of layers 25 and 28 is then etched back relative to the ILD material 35, as shown in Figure 13, and the obtained recess is filled with a second enveloping layer 35' of SiOx, deposited also on the planarized ILD surface, as illustrated in Figure 14. If the conformal SiN layers 25 and 28 are not formed, the steps illustrated in Figures 12 to 14 are skipped. If only layer 28 is formed, the steps shown in Figures 12 to 14 are performed, but the SiN layer on top of the top electrode 18 is then a single SiN encapsulation layer.

In the embodiment shown, the second ILD enveloping layer 35' is SiOx, i.e. the same material as the hardmask 16, so that the hardmask 16 may merge with the deposited ILD material. The second SiOx layer 35' may also merge with the originally deposited and planarized SiOx layer 35, so that layers 35, 16 and 35' form one continuous enveloping layer. It is however possible also that at least one of layers 16, 35 and 35' is not formed of the same oxide as the others and/or that on or more different deposition techniques are applied for producing said layers 16,35,35'

The result of the conformal layer depositions 25,28 and of the ILD deposition steps is that the JJ device 21 is embedded in dielectric material. In the specific embodiment shown, the 'embedding dielectric material' includes the conformal SiN layers 25 and 28 and the enveloping ILD layers 35 and 35'. If no conformal layers are formed, the 'embedding dielectric material' only includes ILD material.

As illustrated in Figure 15, the ILD material 35+35' is subsequently thinned and planarized to the level of the top NbTiN electrode 18. The planarization step removes the remaining edges of the conformal SiN layers 25 and 28 and stops on the surface of the top electrode 18. This is the 'first planarization step in the broadest definition of the invention. In this broadest definition, the conformal layers 25,28 are optional, i.e. the previously described planarization illustrated in Figure 12 is also optional.

The CMP stopping function of NbTiN in this way has not previously been described in the prior art. So far in the prior art, the hardmask for patterning NbTiN has included at least one CMP stopping layer such as a SiN layer, for which this CMP stopping function is well known, i.e. applicable CMP recipes and conditions are known for realizing the function. The functionality is based on the detection of an increase in the required force on the CMP polishing pad for removing ILD material such as SiOx, indicating that the surface of a SiN layer is reached, which signals the time to stop the CMP action. The inventors have found that the same recipes and conditions are in fact applicable also when NbTiN is used as the CMP stopping surface.

This step thereby enables to obtain a first planarized ILD surface 36 that is coplanar with the upper surface of the top electrode 18. This in turn enables contacting the top and bottom electrode of the JJ device in a different way compared to prior art connection schemes. This result is obtained by the fact that at the stage shown in Figure 14, the JJ device 21 as such is embedded in dielectric material that can be planarized by a CMP recipe that stops on the NbTiN surface of the top electrode 18.

The illustrated process sequence describes one way of arriving at this embedded state of the JJ device : by providing the hardmask for patterning the top electrode 18 in the form of a single SiOx layer 16, i.e. this hardmask itself does not include a layer that functions as a CMP stopping layer in a CMP process for planarizing SiOx. In the embodiment shown, the hardmask remains on top of the top electrode but merges with the ILD material, thereby contributing to the 'embedding dielectric material'. Another way could be to provide a hardmask that is fully consumed by the etching process for producing the top electrode 18 and the interlayer 17. The subsequently deposited ILD material then fully envelops the JJ device, together with the conformal layers 25,28, if present.

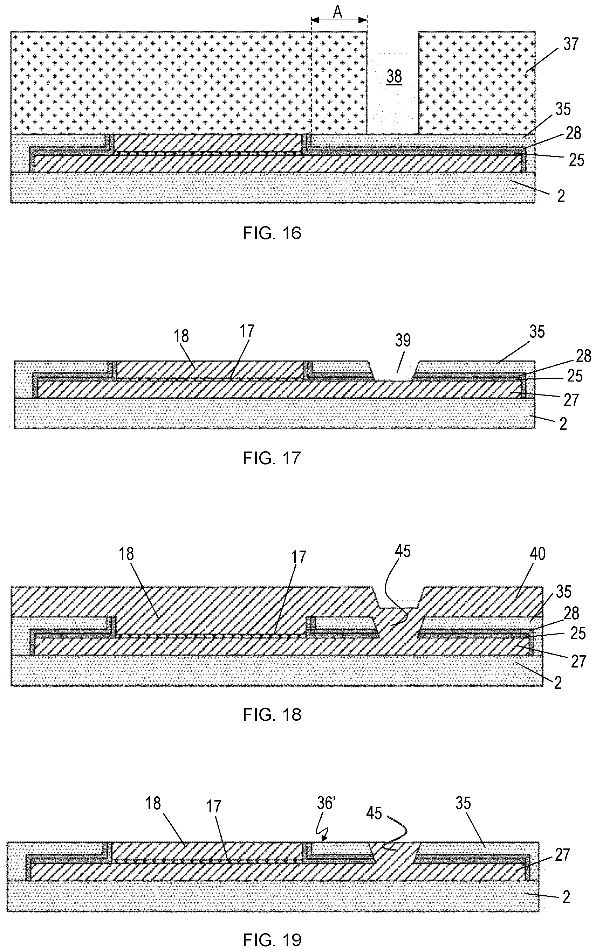

With reference to Figure 16, a hardmask 37 is formed on the first planarized surface 36 and patterned according to the illustrated pattern, including an opening 38 adjacent to the top electrode 18 and lying within the footprint of the line-shaped bottom electrode 27. The opening 38 is preferably located in the middle of the width of the line-shaped bottom electrode 27, and separated from the top electrode by a distance A, which is preferably at least about 190 nm in this particular embodiment to avoid overlay errors (although according to other embodiments, the opening 38 may be situated anywhere in the layout, see further). The hardmask 37 can again be obtained by forming an SOC/SOG/resist stack, as described above, wherein the resist is patterned and wherein the resist pattern is transferred to the underlying SOC/SOG stack.

The opening 38 is then transferred by etching into the ILD material 35 and the SiN layers 25 and 28, or only into the ILD material if the SiN layers 25 and 28 are not applied. Etch recipes and conditions for etching these materials relative to an SOC/SOG hardmask are known as such. The result is an opening 39 through the ILD and SIN layers as shown in Figure 17, after stripping of the SOC/SOG hardmask 37. The sidewalls of the opening 39 may be slanted towards the centre of the opening due to the fact that the etch process is not purely anisotropic. The in-plane dimensions of the opening are however chosen so that a small portion of the upper surface of the line-shaped electrode 27 is exposed at the bottom of the opening 39. Preferably the diameter of the small exposed portion of said upper surface is at least 100 nm.

This is followed by the deposition of an electrically conductive material 40, which can be either be superconducting (e.g. superconducting NbTiN) or non-superconducting, in the opening and on top of the planarized surface, as shown in Figure 18. Preferably an Ar-based cleaning is performed before depositing the conductive material by physical vapour deposition (PVD), applying suitable conditions for filling the opening without void formation, to thereby form a reliable via connection 45.

With reference to Figure 19, the electrically conductive material 40 is then planarized by a further CMP step stopping on the ILD material 35, SiOx in the illustrated example. CMP recipes and conditions for planarizing for example NbTiN and stopping on SiOx are known as such. The result is a second planarized ILD surface 36', with the upper surfaces of a via connection 45 and of the top electrode 18 being coplanar with said second planarized surface 36'.

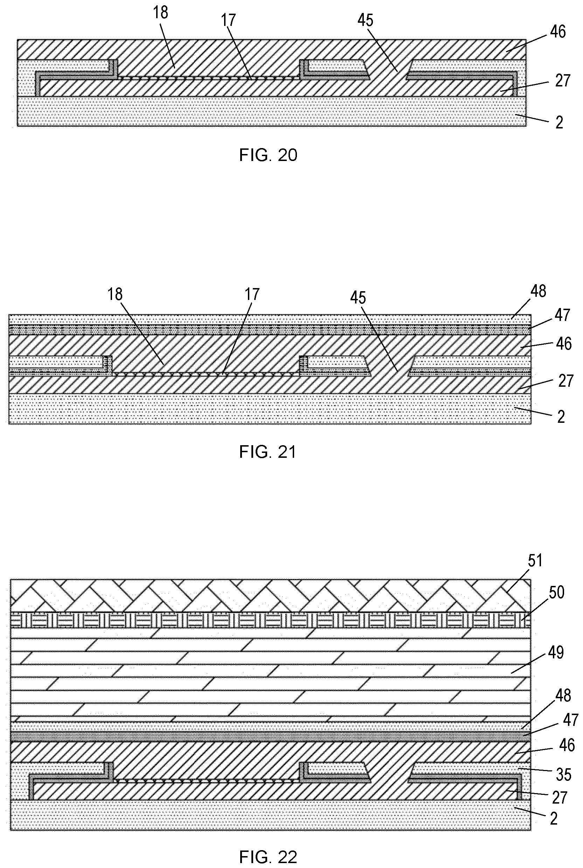

With reference to Figure 20, a further electrically conductive layer 46, which may again be a layer of superconducting NbTiN or other superconducting or non-superconducting material, is then produced on the second planarized surface 36', having about the same thickness as the electrodes 27 and 18, i.e. about 50 nm in the represented example. When this layer 46 is formed of NbTiN, the layer may be patterned by a known patterning technique, involving a hardmask that comprises a SiN layer acting as CMP stopping layer, as described hereafter.

On top of the further NbTiN layer 46 (see Figure 21), a stack of layers 47 and 48 is formed, consisting of a SiN layer 47 and a SiOx layer 48, each of about 30 nm thick.

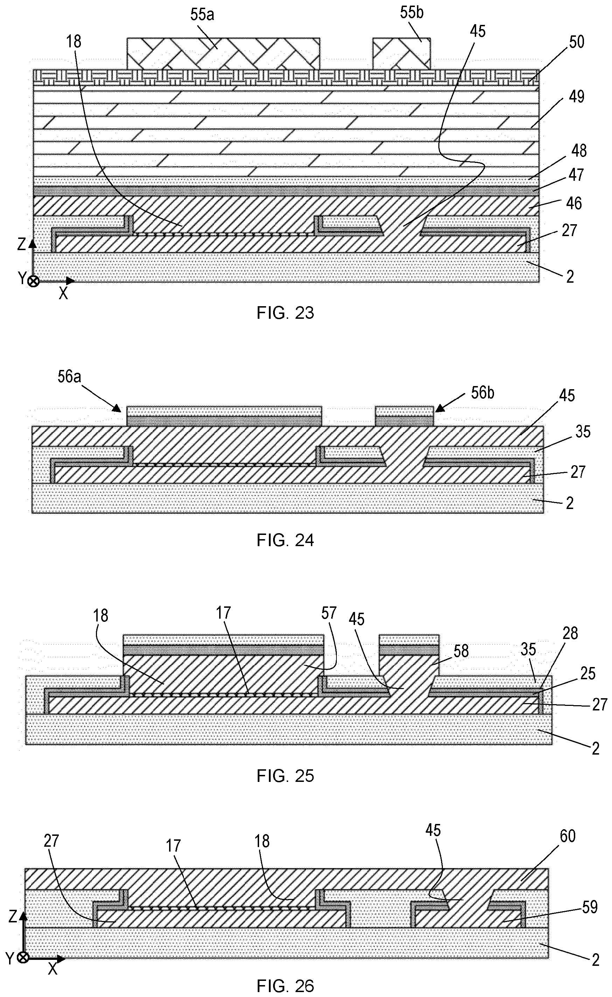

With reference to Figure 22, a lithographic stack is produced on the SiOx layer 48. The lithographic stack may comprise the same layers as the stack 8,9,10 shown in Figure 1 : an amorphous carbon layer 49, a SiOC layer 50 and a resist layer 51. The resist layer is patterned in accordance with the pattern illustrated in Figure 23 : resist mask portions 55a and 55b are formed, extending in the Y-direction, and located respectively above the top electrode 18 of the JJ device and above the via connection 45.

The resist pattern 55a,55b is then transferred to the SiOx layer 48 and the SiN layer 47, as shown in Figure 24 and the lithographic stack is stripped, forming hardmask portions 56a and 56b formed of patterned portions of the SiN/SiOC stack.

With reference to Figure 25, the hardmask portions 56a and 56b are transferred by etching to the NbTiN layer 46, thereby forming conductors 57 and 58 extending in the Y-direction. These conductors are part of the metallization level above the level that contains the JJ-device. The conductors 57 and 58 could also be oriented in the X-direction, or one could be oriented in X and the other in Y. The fabrication process for forming the circuit then continues with steps known as such in the art, including further ILD deposition, planarizing the ILD and stopping on the SIN layers of the hardmask portions 56a and 56b, forming via openings through the SiN layers, filling the via openings with electrically conductive material, planarizing and further forming conductors of the next metallization level.

The invention is not limited to the exact sequence of steps described above. The method is characterized by the enablement of a method step wherein an ILD layer is planarized by CMP stopping on the superconducting NbTiN of an upper electrode of a two-electrode structure. The two-electrode structure can be a JJ device but it could also be a capacitor. In the latter case, the interlayer between the electrodes 27 and 18 is a dielectric material, for example Hafnium Zirconium oxide (Hf_{0.5}Zr_{0.5}O₂ or abbreviated as HZO). Other than that, all method steps described above are applicable for producing contacts to the upper and lower electrodes of a capacitor integrated in an digital logic circuit.

Furthermore, the invention is not limited to methods wherein the via connection 45 contacts the lower electrode of the two-electrode structure. The via connection can contact any conductor lying at the same level as the bottom electrode, and patterned during the same patterning step as the bottom electrode. Figure 26 illustrates an embodiment wherein the bottom electrode of the JJ device extends in the Y-direction, and wherein the via connection 45 contacts a conductor 59 extending also in the Y-direction. Through a conductor 60 extending in the X-direction, the via connection 45 now connects the top electrode 18 of the JJ device to the conductor 59.

According to yet other embodiments, the via connection 45 is not directly coupled by a single conductor in one horizontal plane to either the top or bottom electrode of the two-electrode structure (e.g. JJ device or capacitor), but said connection can be realized through further via connections and conductors of metallization levels lying above or below the two-electrode structure in a BEOL type metallization stack. The via connection 45 need therefore not be directly adjacent the two-electrode structure, but can be anywhere in the layout.

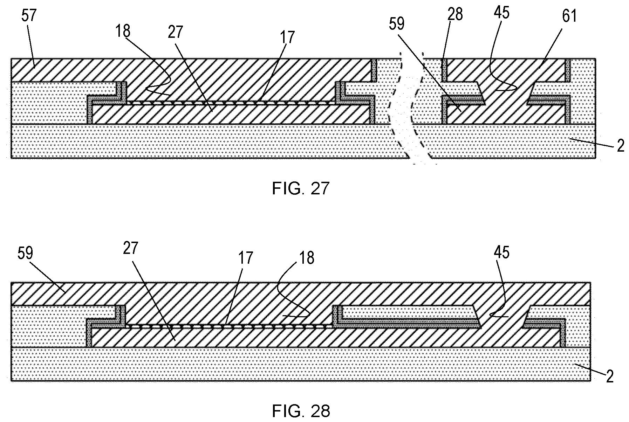

Additional examples of configurations obtainable by the method of the invention are illustrated in Figures 27 and 28. In Figure 27, the via connection 45 is connected to a conductor 61 in the upper level and this conductor and the via connection 45 are not directly adjacent the JJ device. It is seen that the conductors 57,61 of the upper level are preferably also encapsulated by a conformal dielectric layer 28. In Figure 28, the via connection 45 and the conductor 59 directly connect the bottom electrode 27 to the top electrode 18.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for producing a two-electrode structure (21) suitable for being implemented in a digital logic circuit, wherein the top and bottom electrodes are formed of superconducting NbTiN and are separated by a non-superconducting interlayer (17), the method comprising the steps of :
- producing a bottom layer (3) of superconducting NbTiN on a planar support substrate (2),
- producing a middle layer (4) of non-superconducting material on the bottom layer (3),
- producing a top layer (5) of superconducting NbTiN on the middle layer (4),
- patterning the top layer (5) and the middle layer (4) to form a localized stack (20) comprising the top electrode (18) and the interlayer (17) of the two-electrode structure, the top electrode (18) having an upper surface,
- patterning the bottom layer (3) to form the bottom electrode (27) of the two-electrode structure as well as one or more additional layer portions (29,59) at the same level as the bottom electrode (27), the bottom electrode (27) and said layer portions having an upper surface,
- producing one or more layers (35,25,28) of dielectric material, to thereby embed the two-electrode structure in dielectric material, said material being hereafter referred to as 'embedding dielectric material',
- in a first planarization step, planarizing the embedding dielectric material, wherein said planarizing includes a Chemical Mechanical Polishing, i.e. CMP step that is stopped on the upper surface of the top electrode (18), thereby obtaining a first planarized dielectric surface (36) that is coplanar with the upper surface of the top electrode (18),
- thereafter, producing a via opening (39) through said embedding dielectric material, thereby exposing, at the bottom of the via opening, the upper surface of the bottom electrode (27) or of one of said additional layer portions (29,59),
- producing a first additional layer of electrically conductive material, thereby filling the via opening (39) and forming an elecrically conductive layer (40) on the first planarized surface (36),
- in a second planarization step, planarizing the electrically conductive layer (40), comprising a CMP step that is stopped on the embedding dielectric material, thereby obtaining a second planarized surface (36') comprising a dielectric surface that is coplanar with the upper surface of the top electrode (18) and with the upper surface of a via connection (45) formed by filling the via opening (39),
- producing a second additional layer (46) of electrically conductive material on the second planarized surface (36'),
- patterning the second additional layer (46), to thereby form one or more conductors (57,58,60,61) connected to the top electrode (18) and/or to the via connection (45).

2. The method according to claim 1, wherein the step of patterning the top layer (5) and the middle layer (4) is performed by producing a patterned hardmask (16) on the top layer (5) and transferring the shape of the patterned hardmask (16) to the top layer and the middle layer, and wherein the hardmask consists of a single layer (16) of a dielectric material that is either removed completely during said transferring of the shape of the hardmask or that becomes part of said localized stack and of said embedding dielectric material after producing said one or more layers of dielectric material and before the first planarization step.

3. The method according to claim 2, comprising :
- producing a dielectric layer (25,28) conformally on the bottom electrode (27) and the localized stack (20),
- producing a first enveloping dielectric layer (35) on the conformal dielectric layer (25,28),
- planarizing the first enveloping dielectric layer (35), including a CMP step that is stopped on the conformal dielectric layer (25,28),
- removing the conformal dielectric layer (25,28) from the upper surface of the top electrode (18),
- producing a second enveloping dielectric layer (35') on the first enveloping dielectric layer (35) to form a stack of the first and second enveloping dielectric layer,
- performing said first planarization step on the stack formed of the first and second enveloping dielectric layers (35,35'), stopping on the surface of the top electrode (18).

4. The method according to claim 3, wherein the conformal layer is a single layer (28) formed conformally on the bottom electrode (27) and the localized stack (20), after the step of patterning the bottom layer (3).

5. The method according to claim 3, wherein the conformal layer is formed by depositing a first conformal layer (25) on the localized stack (20) before patterning the bottom layer (3) and by depositing a second conformal layer (28) after patterning the bottom layer (3).

6. The method according to any one of claims 3 to 5, wherein the conformal dielectric layer (25,28) is formed of silicon nitride.

7. The method according to any one of the preceding claims, wherein the embedding dielectric material is silicon oxide.

8. The method according to any one of the preceding claims, wherein the two-electrode structure is a Josephson Junction device.

9. The method according to any one of claims 1 to 7, wherein the two-electrode structure is a capacitor.

10. A digital logic circuit comprising one or more Josephson junction devices and/or one or more capacitors produced by the method according to any one of the preceding claims.
